# EUROPEAN PATENT APPLICATION

(11) **EP 4 350 990 A1**
(43) Date of publication of application: **10.04.2024**
(21) Application number: 23185773.1
(22) Date of filing: 17.07.2023
(51) Int. Cl.: H03H 17/02, H03H 17/06

(54) **FLEXIBLE CIRCUIT FOR REAL AND COMPLEX FILTER OPERATIONS**

(30) Priority: 30.09.2022 US 202217957339
(71) Applicant: INTEL Corporation, Santa Clara, CA 95054 (US)
(72) Inventor: LANGHAMMER, Martin, Alderbury, SP53AB (GB)
(74) Representative: Viering, Jentschura & Partner mbB Patent- und Rechtsanwälte

(57) **Abstract**

Integrated circuit devices, methods, and circuitry for implementing and using a flexible circuit for real and complex filter operations are provided. An integrated circuit may include programmable logic circuitry and digital signal processor (DSP) blocks. The DSP blocks may be configurable to receive inputs from the programmable logic circuitry and may include first and second multiplier pairs. The first multiplier pair may include a first multiplier that may receive a first input and a second input and a second multiplier that may receive the second input and a third input of the inputs. The second multiplier pair may include a third multiplier that may receive the first input or a fourth input and a fifth input and a fourth multiplier that may receive the third input or a fifth input and a sixth input.

## Description

### BACKGROUND

This disclosure relates to area-efficient circuitry of an integrated circuit that can perform filtering using both real and complex numerical formats.

This section is intended to introduce the reader to various aspects of art that may be related to various aspects of the present disclosure, which are described and/or claimed below. This discussion is believed to be helpful in providing the reader with background information to facilitate a better understanding of the various aspects of the present disclosure. Accordingly, it may be understood that these statements are to be read in this light, and not as admissions of prior art.

Integrated circuits are found in numerous electronic devices and provide a variety of functionality. Many integrated circuits include arithmetic circuit blocks to perform arithmetic operations such as addition and multiplication. For example, a digital signal processing (DSP) block may supplement programmable logic circuitry in a programmable logic device, such as a field programmable gate array (FPGA). In some integrated circuits, DSP blocks are used in symmetric finite impulse response (FIR) filters. This is often supported by a pre-adder before the multipliers. But the pre-adders may be disruptive in deep submicron (DSM) integrated circuits, since using a pre-adder may entail adding a register stage to meet timing closure with low threshold voltage (Vt) gates. This may take up valuable die area of the integrated circuit.

### BRIEF DESCRIPTION OF THE DRAWINGS

Various aspects of this disclosure may be better understood upon reading the following detailed description and upon reference to the drawings in which:
FIG. 1 is a block diagram of a system used to program an integrated circuit device;
FIG. 2 is a block diagram of the integrated circuit device of FIG. 1;
FIG. 3 is a block diagram of a symmetric finite impulse response (FIR) filter that may be formed using digital signal processing (DSP) blocks of the integrated circuit device;
FIG. 4 is a block diagram of arithmetic circuitry of a DSP block that may be used in a symmetric FIR filter;
FIG. 5 is a block diagram of more efficient arithmetic circuitry of a DSP block that may be used in a symmetric FIR filter;
FIG. 6 is a block diagram of arithmetic circuitry of a DSP block that may be used in a symmetric FIR filter or complex multiplication;
FIG. 7 is a block diagram of the arithmetic circuitry of the DSP of FIG. 6 being used for complex multiplication; and
FIG. 8 is a block diagram of a data processing system that may incorporate the integrated circuit with the testbench soft processor.

### DETAILED DESCRIPTION OF SPECIFIC EMBODIMENTS

One or more specific embodiments will be described below. In an effort to provide a concise description of these embodiments, not all features of an actual implementation are described in the specification. It should be appreciated that in the development of any such actual implementation, as in any engineering or design project, numerous implementation-specific decisions must be made to achieve the developers' specific goals, such as compliance with system-related and business-related constraints, which may vary from one implementation to another. Moreover, it should be appreciated that such a development effort might be complex and time consuming, but would nevertheless be a routine undertaking of design, fabrication, and manufacture for those of ordinary skill having the benefit of this disclosure.

When introducing elements of various embodiments of the present disclosure, the articles "a," "an," and "the" are intended to mean that there are one or more of the elements. The terms "comprising," "including," and "having" are intended to be inclusive and mean that there may be additional elements other than the listed elements. Additionally, it should be understood that references to "one embodiment" or "an embodiment" of the present disclosure are not intended to be interpreted as excluding the existence of additional embodiments that also incorporate the recited features.

Pre-adders are used in a variety of arithmetic operations to add signals together before a multiplication operation. Although adders are much smaller physically than multipliers of the same bit depth, adders cannot be easily combined with the multiplier logic, and the output must be completely calculated (in a carry propagate manner) before inputting to the multiplier. In practice, this involves the insertion of a register stage between the adder and multiplier. This register stage takes up additional area and power.

Rather than use a pre-adder before multiplication, addition operations that would otherwise occur in a pre-adder may be accomplished using multipliers. This may reduce the area used by the arithmetic circuitry while computing the same answer. For example, a digital signal processing (DSP) block of an integrated circuit may use four multipliers rather than use two multipliers and two pre-adders. In addition, the quad multipliers of the DSP block may be readily repurposed into a complex multiplier. This approach gives the same symmetric FIR density as the known approach, but at a lower latency. In addition, complex multiplication can be directly supported, doubling the effective arithmetic capability of the block. As such, this disclosure describes an arrangement of multipliers, adders, and multiplexers in a DSP block that can support both complex multiplication and real multiplication. The DSP block may be well suited for the implementation of FIR filtering operations.

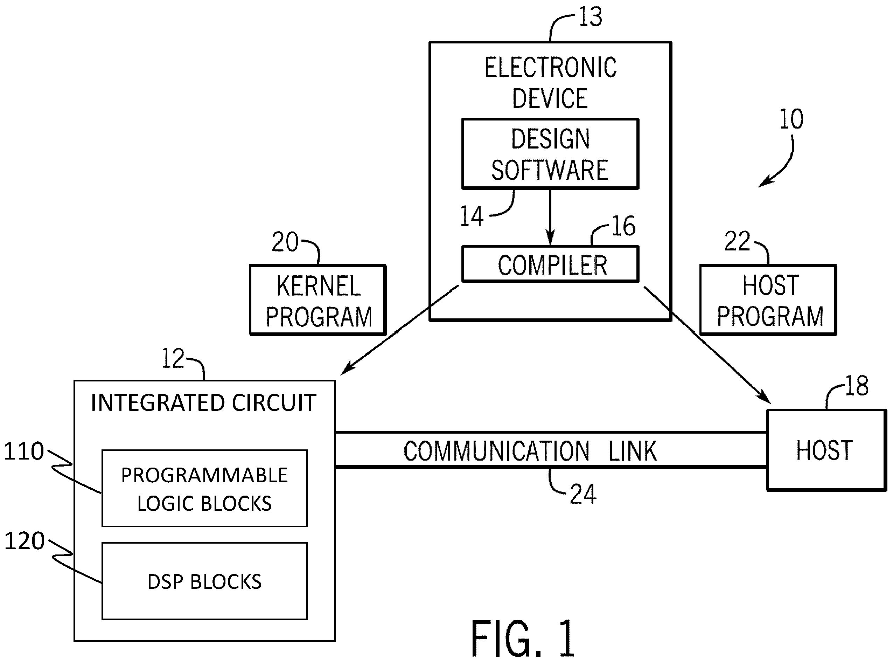

With the foregoing in mind, FIG. 1 illustrates a block diagram of a system 10 that may be used in configuring an integrated circuit 12 with such a DSP block. A designer may desire to implement testbench functionality on the integrated circuit 12 (e.g., a programmable logic device such as a field-programmable gate array (FPGA) or an application-specific integrated circuit (ASIC) that includes programmable logic circuitry). The integrated circuit 12 may include a single integrated circuit, multiple integrated circuits in a package, or multiple integrated circuits in multiple packages communicating remotely (e.g., via wires or traces). In some cases, the designer may specify a high-level program to be implemented, such as an OPENCL^{®} program that may enable the designer to more efficiently and easily provide programming instructions to configure a set of programmable logic cells for the integrated circuit 12 without specific knowledge of low-level hardware description languages (e.g., Verilog, very high speed integrated circuit hardware description language (VHDL)). For example, since OPENCL^{®} is quite similar to other high-level programming languages, such as C++, designers of programmable logic familiar with such programming languages may have a reduced learning curve than designers that are required to learn unfamiliar low-level hardware description languages to implement new functionalities in the integrated circuit 12.

In a configuration mode of the integrated circuit 12, a designer may use an electronic device 13 (e.g., a computer) to implement high-level designs (e.g., a system user design) using design software 14, such as a version of INTEL^{®} QUARTUS^{®} by INTEL CORPORATION. The electronic device 13 may use the design software 14 and a compiler 16 to convert the high-level program into a lower-level description (e.g., a configuration program, a bitstream). The compiler 16 may provide machine-readable instructions representative of the high-level program to a host 18 and the integrated circuit 12. The host 18 may receive a host program 22 that may be implemented by the kernel programs 20. To implement the host program 22, the host 18 may communicate instructions from the host program 22 to the integrated circuit 12 via a communications link 24 that may be, for example, direct memory access (DMA) communications or peripheral component interconnect express (PCIe) communications. In some embodiments, the kernel programs 20 and the host 18 may enable configuration of programmable logic blocks 110 on the integrated circuit 12. The programmable logic blocks 110 may include circuitry and/or other logic elements and may be configurable to implement a variety of functions, including symmetric finite impulse response (FIR) filtering, in combination with digital signal processing (DSP) blocks.

The designer may use the design software 14 to generate and/or to specify a low-level program, such as the low-level hardware description languages described above. Further, in some embodiments, the system 10 may be implemented without a separate host program 22. Thus, embodiments described herein are intended to be illustrative and not limiting.

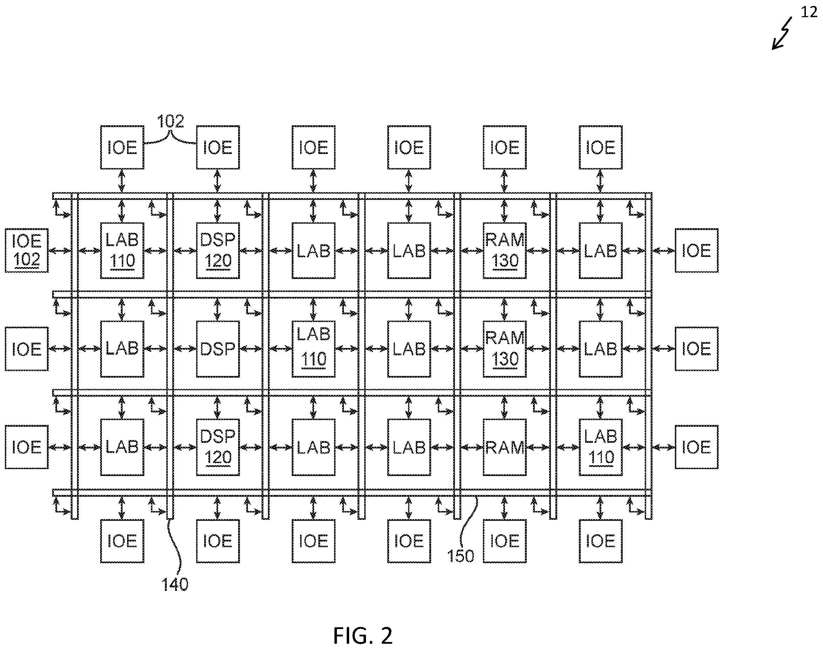

An illustrative embodiment of a programmable integrated circuit 12 such as a programmable logic device (PLD) that may be configured to implement a circuit design is shown in FIG. 2. As shown in FIG. 2, the integrated circuit 12 (e.g., a field-programmable gate array integrated circuit die) may include a two-dimensional array of functional blocks, including programmable logic blocks 110 (also referred to as logic array blocks (LABs) or configurable logic blocks (CLBs)) and other functional blocks, such as random-access memory (RAM) blocks 130 and digital signal processing (DSP) blocks 120, for example. Functional blocks such as LABs 110 may include smaller programmable regions (e.g., logic elements, configurable logic blocks, or adaptive logic modules) that receive input signals and perform custom functions on the input signals to produce output signals. LABs 110 may also be grouped into larger programmable regions sometimes referred to as logic sectors that are individually managed and configured by corresponding logic sector managers. The grouping of the programmable logic resources on the integrated circuit 12 into logic sectors, logic array blocks, logic elements, or adaptive logic modules is merely illustrative. In general, the integrated circuit 12 may include functional logic blocks of any suitable size and type, which may be organized in accordance with any suitable logic resource hierarchy.

Programmable logic the integrated circuit 12 may contain programmable memory elements. Memory elements may be loaded with configuration data (also called programming data or configuration bitstream) using input-output elements (IOEs) 102. Once loaded, the memory elements each provide a corresponding static control signal that controls the operation of an associated functional block (e.g., LABs 110, DSP 120, RAM 130, or input-output elements 102).

In one scenario, the outputs of the loaded memory elements are applied to the gates of metal-oxide-semiconductor transistors in a functional block to turn certain transistors on or off and thereby configure the logic in the functional block including the routing paths. Programmable logic circuit elements that may be controlled in this way include parts of multiplexers (e.g., multiplexers used for forming routing paths in interconnect circuits), look-up tables, logic arrays, AND, OR, NAND, and NOR logic gates, pass gates, etc.

The memory elements may use any suitable volatile and/or non-volatile memory structures such as random-access-memory (RAM) cells, fuses, antifuses, programmable read-only-memory memory cells, mask-programmed and laser-programmed structures, combinations of these structures, etc. Because the memory elements are loaded with configuration data during programming, the memory elements are sometimes referred to as configuration memory, configuration random-access memory (CRAM), or programmable memory elements. Programmable logic device (PLD) 100 may be configured to implement a custom circuit design. For example, the configuration RAM may be programmed such that LABs 110, DSP 120, and RAM 130, programmable interconnect circuitry (i.e., vertical channels 140 and horizontal channels 150), and the input-output elements 102 form the circuit design implementation.

In addition, the programmable logic device may have input-output elements (IOEs) 102 for driving signals off of the integrated circuit 12 and for receiving signals from other devices. Input-output elements 102 may include parallel input-output circuitry, serial data transceiver circuitry, differential receiver and transmitter circuitry, or other circuitry used to connect one integrated circuit to another integrated circuit.

The integrated circuit 12 may also include programmable interconnect circuitry in the form of vertical routing channels 140 (i.e., interconnects formed along a vertical axis of the integrated circuit 100) and horizontal routing channels 150 (i.e., interconnects formed along a horizontal axis of the integrated circuit 100), each routing channel including at least one track to route at least one wire. If desired, the interconnect circuitry may include pipeline elements, and the contents stored in these pipeline elements may be accessed during operation. For example, a programming circuit may provide read and write access to a pipeline element.

Note that other routing topologies, besides the topology of the interconnect circuitry depicted in FIG. 1, are intended to be included within the scope of the present invention. For example, the routing topology may include wires that travel diagonally or that travel horizontally and vertically along different parts of their extent as well as wires that are perpendicular to the device plane in the case of three-dimensional integrated circuits, and the driver of a wire may be located at a different point than one end of a wire. The routing topology may include global wires that span substantially all of the integrated circuit 12, fractional global wires such as wires that span part of the integrated circuit 12, staggered wires of a particular length, smaller local wires, or any other suitable interconnection resource arrangement.

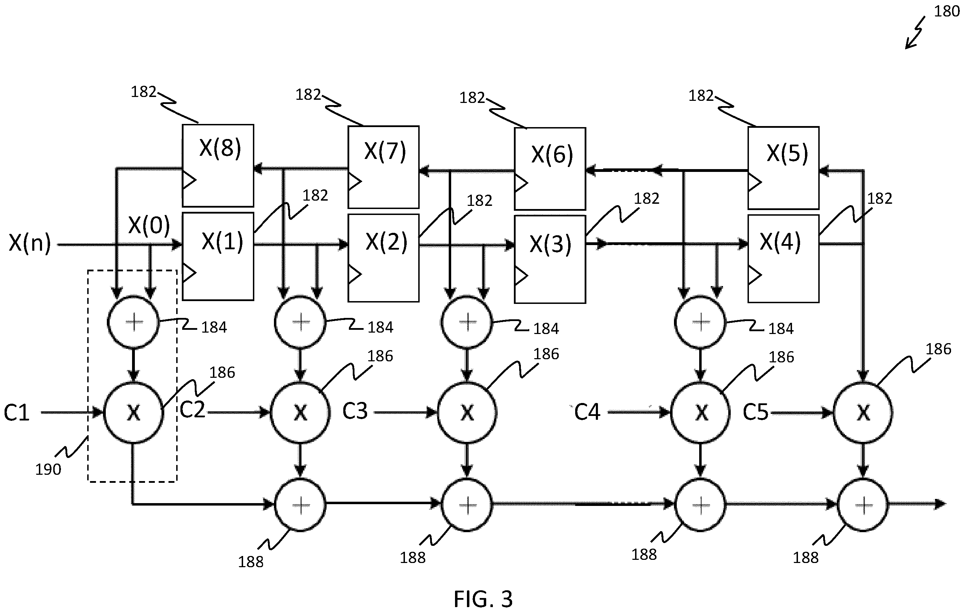

The integrated circuit 12 may be programmed to perform a wide variety of operations. One example shown in FIG. 3 is symmetric finite impulse response (FIR) filtering. Symmetric FIR filters are those where the weights are the same magnitude around some defined point. For example, a 15-tap FIR filter (where taps are indexed 1.. 15), will have weights the same magnitude at indexes 1 and 15, 2 and 14, 3 and 13, and so on, and tap 8 will be a single value in the middle. This can also be applied to filters with even number of taps, for example an 8 tap filter. In that case, taps 1,2,3,4 will have the same weight magnitudes as taps 8,7,6, and 5, respectively.

In the example of FIG. 3, a symmetric FIR filter 180 receives an input signal x(n). The FIR filter 180 has 9 taps symmetric to a point x(4) of the signal x(n) when the first point in the x(n) signals is x(0). The x(n) signal traverses registers 182 that provide the tap points into a pre-adder 184 before the results enter a multiplier 186 to multiply by a weight value (here, coefficients C1, C2, C3, C4, or C5). The partial results are summed together in adders 188 to obtain the result of the filter 180. In some cases, the weights will have the same magnitude, but a different sign. In such cases, the pre-adder 184 may be configurable as a presubtractor.

Support for symmetric filters is provided by the pre-adder 184 in front of the multiplier 186. Some DSP blocks 120 may have 1 or 2 multipliers, although more multipliers are possible. The advantage of the method shown in FIG. 3 is that about half the number of multipliers (half+1 in the case of an odd length filter) are used to implement a symmetric FIR filter, compared to providing a multiplier 186 for each tap. Before continuing, it should be noted that the example of a symmetric FIR filter is purely illustrative. There are many other applications for pre-adders 184 as well.

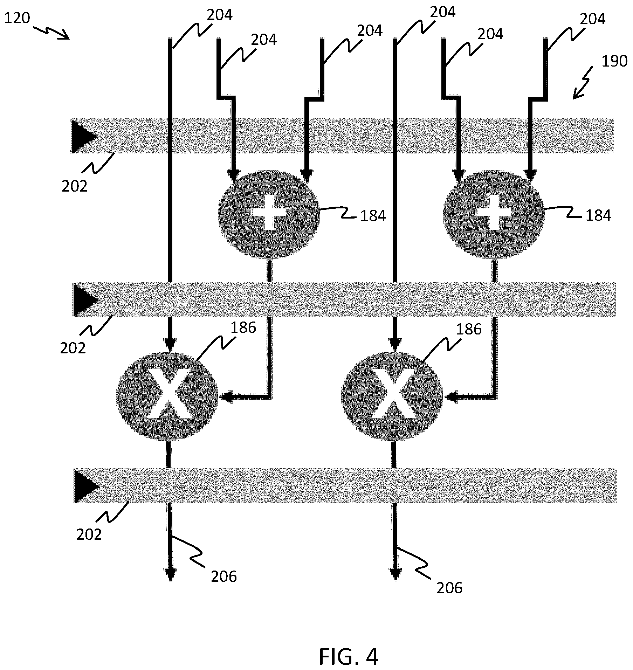

In one example, arithmetic circuitry 190 of the filter 180 may be provided by a digital signal processing (DSP) block 120 of the integrated circuit 12, as shown in FIG. 4. Indeed, an adder 184 is typically much smaller than a multiplier 186 of the same precision. Replacing a multiplier 186 function with an adder 184 function is therefore expected to offer advantages in terms of area and power. FIG. 4 shows the logical structure of a DSP block 120 with pre-adder 184 functionality. In this case, register stages 202 receive data from inputs 204 before the data is added in the pre-adders 184 and again before the data is multiplied in the multipliers 186. The results are provided in outputs 206. The results from the multipliers 186 are output directly from the DSP block 120. For FIR filtering, an additional adder may also be provided after the multipliers 186 to add the results together, likely with additional capability to add adjacent DSP blocks 120 together as well to construct the FIR filter 180.

Although the adders 184 are much smaller physically than the multipliers 186, the adders 184 cannot be easily combined with the multiplier 186 logic, and the output of the pre-adder 184 may be completely calculated (e.g., in a carry propagate manner) before inputting to the multiplier 186. In practice, this will involve the insertion of a register stage 202 between the adder 184 and multiplier 186. The additional register stage 202 takes up additional area and power. Note that it is also possible to use synthesis tools and gate library selections to build a faster adder/multiplier pair than will not need a register stage to meet timing, but this will likely result in a much larger circuit. Such a circuit will also have a higher static power consumption, as lower Vt transistors would be used for increased performance. Considering that the integrated circuit 12 may contain thousands of DSP blocks 120, increasing static power consumption in the DSP blocks 120 could be a very bad tradeoff.

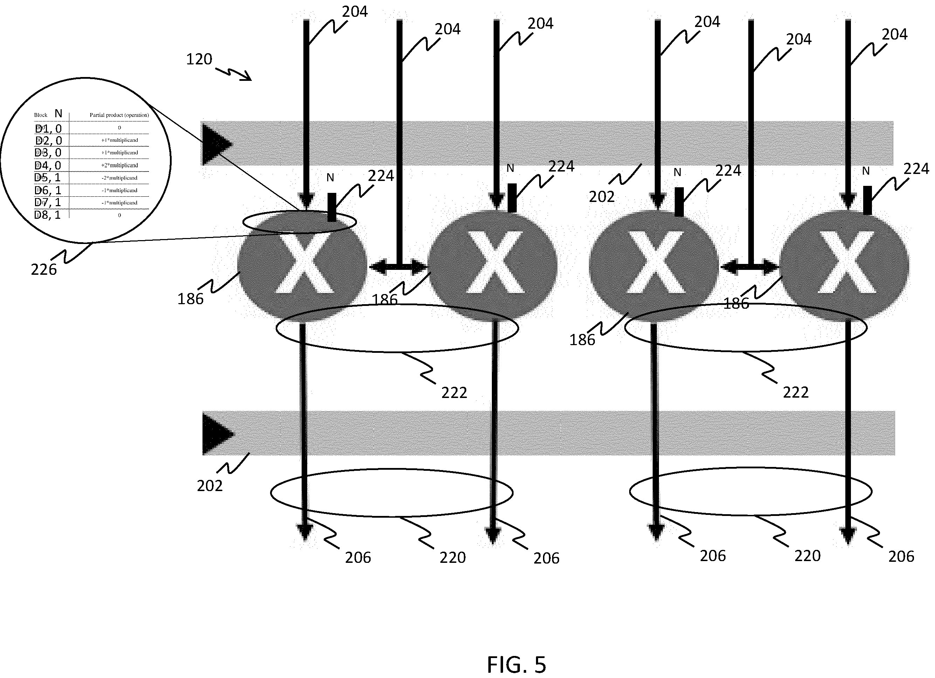

The pre-adders 184 may be removed while maintaining the effectiveness of DSP block 120 for use in a symmetric FIR filter, while improving area-efficiency, by replacing the pre-adders 184 with additional multipliers 186. This is a very unintuitive result. A DSP block 120 of FIG. 5 shows the use of additional multipliers 186 to provide pre-adder 184 functionality so that the DSP block 120 contains circuitry that is functionally equivalent to that of circuitry 190, except more efficient. Here, four multipliers 186 are used. Although the multipliers 186 are larger than the adders 184 they are replacing, there is one fewer register stage 202 (saving space). As a consequence, this design also has a slightly lower latency. The number of inputs 204 (here, 6 wires) in the example of FIG. 5 without pre-adders 184 is the same as in the example of FIG. 4 that includes the pre-adders 184.

Although it appears in FIG. 5 that there are more outputs 206 than need to be processed, this is just a logical representation and the outputs 206 of the respective multipliers 186 may be considered to collectively output a combined result 220. This is because the pair of multipliers 186 may be physically combined 222 at a partial product compression stage in the multipliers 186, before a final carry propagate addition (CPA) occurring as the final stage in the multipliers 186. This is very inexpensive, in both terms of area and speed.

Another consideration is the case where the symmetric weights have the same magnitude, but different signs. This can be handled in several ways. One way is to include a negation signal 224 into the multiplier 186 at a partial product coding layer 226 at the top of the multiplier 186. For example, the negation signal may be a sign bit of a value from an input 204 or may be received separately on a different basis (e.g., may be received from configuration memory or a configuration channel from the programmable logic circuitry blocks 110). The negation signal 224 may be provided when the shared inputs are to represent two values of the same magnitude but different sign. If the negation signal is active, the sign of each partial product is negated. This is a very inexpensive gate change, and does not affect the generation of the partial products, the compression of the partial products, or carry propagate addition. Indeed, this may be done by merely changing the coding control into the partial product generation, which is a small number of bits.

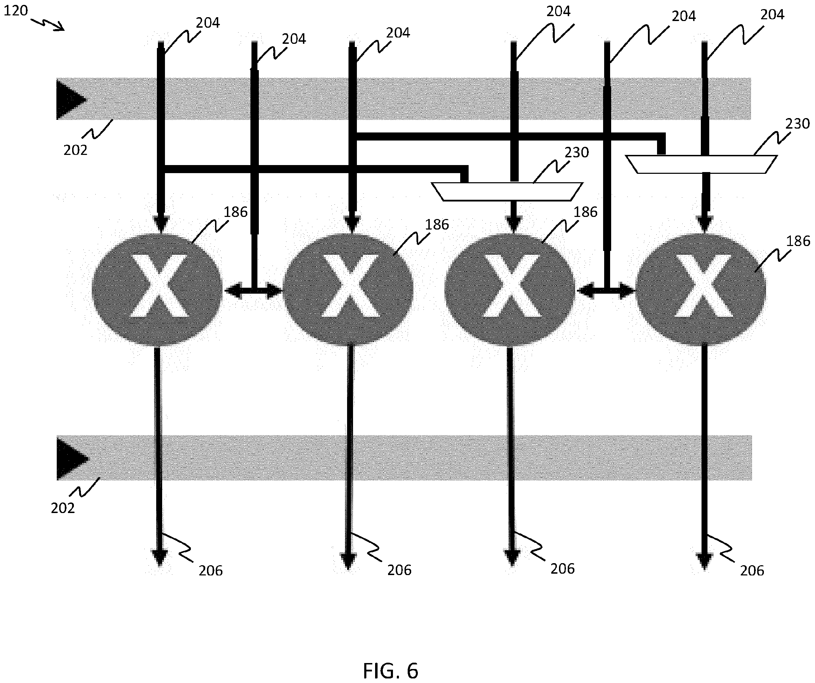

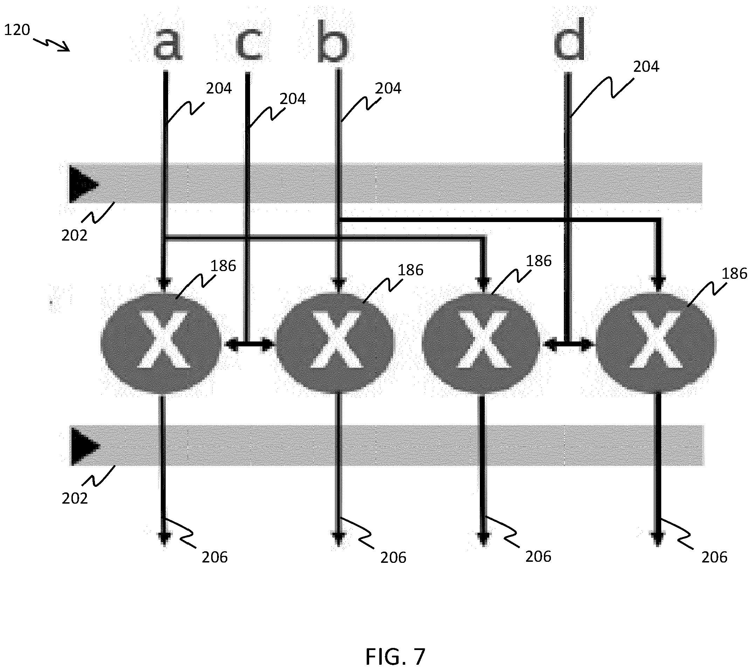

Another advantage of replacing the pre-adders 184 with multipliers 186 is that for the same circuit, with the addition of two multiplexers 230 as shown in FIG. 6, the DSP 110 can also implement a complex multiplier, as shown in FIG. 7. FIG. 7 illustrates the circuitry of FIG. 6 in which the multiplexers 230 are selecting the same inputs 204 as are entering the first two multipliers 186 on the lefthand side of the circuitry. The shared inputs 204 (here 'c' and 'd') are like before, as are the two tap inputs into the left multiplier 186 pair ('a' and 'b'). The tap inputs into the right multiplier 186 pair are multiplexed from 'a' and 'b'. Negation control for the summation of one of the pairs of multipliers 186 is used. For example, if the inputs 204 are (a+bj)(c+dj), the outputs 206 are equal to (ac-bd) + j(ad+bc).

Accordingly, the DSP blocks 120 of this disclosure may have pairs of multipliers arranged such that, for every pair of multipliers, there are three inputs. There may be more or fewer than two pairs of multipliers per DSP block. In some embodiments, the DSP blocks 120 completely lack pre-adders. In other examples, the pre-adders may be present but unused. Moreover, there may be fewer inputs than would be used if the multiplier pairs did not share an input. Indeed, because each pair of multipliers shares one of its inputs with the other and has a unique input that is not shared with the other multiplier, a DSP block with four multipliers may effectively receive eight inputs to the multipliers while only having six inputs to the DSP block.

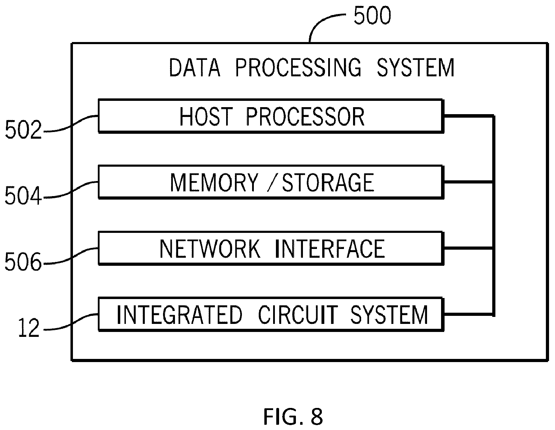

The integrated circuit system 12 may be a component included in a data processing system, such as a data processing system 500, shown in FIG. 8. The data processing system 500 may include the integrated circuit system 12 (e.g., a programmable logic device), a host processor 502, memory and/or storage circuitry 504, and a network interface 506. The data processing system 500 may include more or fewer components (e.g., electronic display, user interface structures, application specific integrated circuits (ASICs)). The integrated circuit 12 may be used to efficiently implement a symmetric FIR filter or perform complex multiplication. The host processor 502 may include any of the foregoing processors that may manage a data processing request for the data processing system 500 (e.g., to perform encryption, decryption, machine learning, video processing, voice recognition, image recognition, data compression, database search ranking, bioinformatics, network security pattern identification, spatial navigation, cryptocurrency operations, or the like). The memory and/or storage circuitry 504 may include random access memory (RAM), read-only memory (ROM), one or more hard drives, flash memory, or the like. The memory and/or storage circuitry 504 may hold data to be processed by the data processing system 500. In some cases, the memory and/or storage circuitry 504 may also store configuration programs (e.g., bitstreams, mapping function) for programming the integrated circuit system 12. The network interface 506 may allow the data processing system 500 to communicate with other electronic devices. The data processing system 500 may include several different packages or may be contained within a single package on a single package substrate. For example, components of the data processing system 500 may be located on several different packages at one location (e.g., a data center) or multiple locations. For instance, components of the data processing system 500 may be located in separate geographic locations or areas, such as cities, states, or countries.

The data processing system 500 may be part of a data center that processes a variety of different requests. For instance, the data processing system 500 may receive a data processing request via the network interface 506 to perform encryption, decryption, machine learning, video processing, voice recognition, image recognition, data compression, database search ranking, bioinformatics, network security pattern identification, spatial navigation, digital signal processing, or other specialized tasks.

While the embodiments set forth in the present disclosure may be susceptible to various modifications and alternative forms, specific embodiments have been shown by way of example in the drawings and have been described in detail herein. However, it should be understood that the disclosure is not intended to be limited to the particular forms disclosed. The disclosure is to cover all modifications, equivalents, and alternatives falling within the spirit and scope of the disclosure as defined by the following appended claims.

The techniques presented and claimed herein are referenced and applied to material objects and concrete examples of a practical nature that demonstrably improve the present technical field and, as such, are not abstract, intangible or purely theoretical. Further, if any claims appended to the end of this specification contain one or more elements designated as "means for [perform]ing [a function]..." or "step for [perform]ing [a function]...", it is intended that such elements are to be interpreted under 35 U.S.C. 112(f). However, for any claims containing elements designated in any other manner, it is intended that such elements are not to be interpreted under 35 U.S.C. 112(f).

### Example Embodiments

EXAMPLE EMBODIMENT 1. An integrated circuit comprising:
programmable logic circuitry; and
a plurality of digital signal processor (DSP) blocks configurable to receive inputs from the programmable logic circuitry, wherein respective digital signal processing (DSP) blocks of the plurality of digital signal processor (DSP) blocks comprise:
   a first multiplier pair comprising:
   a first multiplier configurable to receive a first input of the inputs and a second input of the inputs; and
   a second multiplier configurable to receive the second input of the inputs and a third input of the inputs; and
a second multiplier pair comprising:
   a third multiplier configurable to receive:
   the first input of the inputs or a fourth input of the inputs; and
   a fifth input of the inputs; and
   a fourth multiplier configurable to receive:
   the third input of the inputs or a fifth input of the inputs; and
   a sixth input of the inputs.

EXAMPLE EMBODIMENT 2. The integrated circuit of example embodiment 1, wherein the programmable logic circuitry and the plurality of digital signal processing blocks are configurable to implement a symmetric finite impulse response (FIR) filter, wherein the first multiplier pair of at least one of the digital signal processing (DSP) blocks of the plurality of digital signal processor (DSP) blocks are configurable to implement two taps of the symmetric finite impulse response (FIR) filter.

EXAMPLE EMBODIMENT 3. The integrated circuit of example embodiment 1, wherein the second of the inputs represents a first value having a first magnitude and a first sign when input into the first multiplier and a second value having the first magnitude and a second sign opposite the first sign when input into the second multiplier.

EXAMPLE EMBODIMENT 4. The integrated circuit of example embodiment 3, wherein the second multiplier is configurable to receive a negation signal instructing the multiplier to apply the second sign.

EXAMPLE EMBODIMENT 5. The integrated circuit of example embodiment 4, wherein the second multiplier comprises a product coding control that uses the negation signal to apply the second sign.

EXAMPLE EMBODIMENT 6. The integrated circuit of example embodiment 4, wherein the negation signal is applied based on a value stored in configuration memory of the integrated circuit.

EXAMPLE EMBODIMENT 7. The integrated circuit of example embodiment 4, wherein the negation signal is applied based on the second of the inputs.

EXAMPLE EMBODIMENT 8. The integrated circuit of example embodiment 1, wherein outputs of the first multiplier and the second multiplier are summed before being output from the respective digital signal processing (DSP) block. EXAMPLE EMBODIMENT 9.

The integrated circuit of example embodiment 8, wherein the first multiplier and the second multiplier are physically combined at a partial product compression stage before a final carry propagate addition (CPA).

EXAMPLE EMBODIMENT 10. The integrated circuit of example embodiment 1, wherein respective digital signal processing (DSP) blocks are configurable to implement a complex multiplier by using the first input and the third input in both the first multiplier and second multiplier.

EXAMPLE EMBODIMENT 11. Digital signal processing circuitry comprising:
input circuitry comprising six inputs;
a first multiplier pair coupled to a first three inputs of the six inputs, wherein one of the first three inputs is shared by the first multiplier pair and the other two of the first three inputs are unshared by the first multiplier pair; and
a second multiplier pair coupled to a second three inputs of the six inputs, wherein one of the second three inputs is shared by the second multiplier pair and the other two of the second three inputs are unshared by the second multiplier pair.

EXAMPLE EMBODIMENT 12. The digital signal processing circuitry of example embodiment 11, wherein the input circuitry consists of the six inputs.

EXAMPLE EMBODIMENT 13. The digital signal processing circuitry of example embodiment 11, wherein the second multiplier pair is coupled to the unshared inputs of the first three inputs of the first multiplier pair, wherein the digital signal processing circuitry comprises a plurality of multiplexers configurable to select between the unshared inputs of the first multiplier pair and the unshared inputs of the second multiplier pair.

EXAMPLE EMBODIMENT 14. The digital signal processing circuitry of example embodiment 13, wherein the digital signal processing (DSP) block is configurable to implement a complex multiplier by selecting the unshared inputs of the first multiplier pair to also go to the second multiplier pair.

EXAMPLE EMBODIMENT 15. The digital signal processing circuitry of example embodiment 11, wherein the first multiplier pair is configurable to interpret the shared input of the first multiplier pair as having a different sign in different multipliers of the first multiplier pair.

EXAMPLE EMBODIMENT 16. The digital signal processing circuitry of example embodiment 15, wherein at least one multiplier of the different multipliers of the first multiplier pair is configurable to receive a negation signal instructing the at least one multiplier to apply the different sign to the shared input from that applied in the other of the first multiplier pair.

EXAMPLE EMBODIMENT 17. The digital signal processing circuitry of example embodiment 15, wherein a product coding control of the first multiplier pair is configurable to apply the different sign based on the negation signal.

EXAMPLE EMBODIMENT 18. The digital signal processing circuitry of example embodiment 11, wherein outputs of the first multiplier pair are summed before being output from the digital signal processing (DSP) block.

EXAMPLE EMBODIMENT 19. The digital signal processing circuitry of example embodiment 18, wherein the first multiplier pair is physically combined at a partial product compression stage before a final carry propagate addition (CPA).

EXAMPLE EMBODIMENT 20. A method comprising:
receiving a plurality of inputs into a digital signal processing block;
providing a first three inputs of the plurality of inputs to a first multiplier pair, wherein one of the first three inputs is shared by the first multiplier pair and the other two of the first three inputs are unshared by the first multiplier pair;
providing a second three inputs of the plurality of inputs to a second multiplier pair, wherein one of the second three inputs is shared by the second multiplier pair and the other two of the second three inputs are unshared by the second multiplier pair;
summing outputs of the first multiplier pair; and
summing outputs of the second multiplier pair.

## Claims

1. An integrated circuit comprising:
programmable logic circuitry; and
a plurality of digital signal processor (DSP) blocks configurable to receive inputs from the programmable logic circuitry, wherein respective digital signal processing (DSP) blocks of the plurality of digital signal processor (DSP) blocks comprise:
a first multiplier pair comprising:
a first multiplier configurable to receive a first input of the inputs and a second input of the inputs; and
a second multiplier configurable to receive the second input of the inputs and a third input of the inputs; and
a second multiplier pair comprising:
a third multiplier configurable to receive:
the first input of the inputs or a fourth input of the inputs;
and
a fifth input of the inputs; and
a fourth multiplier configurable to receive:
the third input of the inputs or a fifth input of the inputs; and
a sixth input of the inputs.

2. The integrated circuit of claim 1, wherein the programmable logic circuitry and the plurality of digital signal processing blocks are configurable to implement a symmetric finite impulse response (FIR) filter, wherein the first multiplier pair of at least one of the digital signal processing (DSP) blocks of the plurality of digital signal processor (DSP) blocks are configurable to implement two taps of the symmetric finite impulse response (FIR) filter.

3. The integrated circuit of claim 1 or 2, wherein the second of the inputs represents a first value having a first magnitude and a first sign when input into the first multiplier and a second value having the first magnitude and a second sign opposite the first sign when input into the second multiplier.

4. The integrated circuit of claim 3, wherein the second multiplier is configurable to receive a negation signal instructing the multiplier to apply the second sign.

5. The integrated circuit of claim 4, wherein the second multiplier comprises a product coding control that uses the negation signal to apply the second sign.

6. The integrated circuit of claim 4, wherein the negation signal is applied based on a value stored in configuration memory of the integrated circuit.

7. The integrated circuit of claim 4, wherein the negation signal is applied based on the second of the inputs.

8. The integrated circuit of any of the preceding claims, wherein outputs of the first multiplier and the second multiplier are summed before being output from the respective digital signal processing (DSP) block.

9. The integrated circuit of claim 8, wherein the first multiplier and the second multiplier are physically combined at a partial product compression stage before a final carry propagate addition (CPA).

10. The integrated circuit of any of the preceding claims, wherein respective digital signal processing (DSP) blocks are configurable to implement a complex multiplier by using the first input and the third input in both the first multiplier and second multiplier.

11. The integrated circuit of any of the preceding claims, wherein the respective digital signal processing (DSP) blocks of the plurality of digital signal processor (DSP) blocks comprise:
input circuitry comprising six inputs;
wherein :
the first multiplier pair is coupled to a first three inputs of the six inputs, wherein one of the first three inputs is shared by the first multiplier pair and the other two of the first three inputs are unshared by the first multiplier pair; and
the second multiplier pair is coupled to a second three inputs of the six inputs, wherein one of the second three inputs is shared by the second multiplier pair and the other two of the second three inputs are unshared by the second multiplier pair.

12. The integrated circuit of any of the preceding claims, wherein the input circuitry consists of the six inputs.

13. The integrated circuit of any of the preceding claims, wherein the second multiplier pair is coupled to the unshared inputs of the first three inputs of the first multiplier pair, wherein the digital signal processing circuitry comprises a plurality of multiplexers configurable to select between the unshared inputs of the first multiplier pair and the unshared inputs of the second multiplier pair.

14. The integrated circuit of claim 13, wherein the respective digital signal processing (DSP) blocks are configurable to implement a complex multiplier by selecting the unshared inputs of the first multiplier pair to also go to the second multiplier pair.

15. A method comprising:
receiving a plurality of inputs into a digital signal processing block;
providing a first three inputs of the plurality of inputs to a first multiplier pair, wherein one of the first three inputs is shared by the first multiplier pair and the other two of the first three inputs are unshared by the first multiplier pair;
providing a second three inputs of the plurality of inputs to a second multiplier pair, wherein one of the second three inputs is shared by the second multiplier pair and the other two of the second three inputs are unshared by the second multiplier pair;
summing outputs of the first multiplier pair; and
summing outputs of the second multiplier pair.
